(19) Europäisches Patentamt
European Patent Office
Office européen des brevets

(11) Veröffentlichungsnummer: **0 023 662**
**B1**

(12) **EUROPÄISCHE PATENTSCHRIFT**

(45) Veröffentlichungstag der Patentschrift: **18.05.83**

(51) Int. Cl.³: **G 03 F 7/08**

(21) Anmeldenummer: **80104288.8**

(22) Anmeldetag: **21.07.80**

(54) **Wärmebeständige Positivresists und Verfahren zur Herstellung wärmebeständiger Reliefstrukturen.**

(30) Priorität: **01.08.79 DE 2931297**

(43) Veröffentlichungstag der Anmeldung: **11.02.81 Patentblatt 81/6**

(45) Bekanntmachung des Hinweises auf die Patenterteilung: **18.05.83 Patentblatt 83/20**

(84) Benannte Vertragsstaaten: **AT BE CH DE FR GB IT LI NL SE**

(56) Entgegenhaltungen:
**DE-A-2 631 535**
**GB-A-1 070 242**

(73) Patentinhaber: **SIEMENS AKTIENGESELLSCHAFT, Berlin und München Wittelsbacherplatz 2, D-8000 München 2 (DE)**

(72) Erfinder: **Ahne, Hellmut, Dr., Heidestrasse 6, D-8551 Röttenbach (DE)**
Erfinder: **Rubner, Roland, Dr., Buchenring 15, D-8551 Röttenbach (DE)**
Erfinder: **Kühn, Eberhard, Bergstrasse 32, D-8551 Hemhofen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

# Wärmebeständige Positivresists und Verfahren zur Herstellung wärmebeständiger Reliefstrukturen

Die Erfindung betrifft wärmebeständige Positivresists auf der Basis von Vorstufen hochwärmebeständiger Polymere und lichtempfindlichen Diazochinonen sowie ein Verfahren zur Herstellung wärmebeständiger Reliefstrukturen aus derartigen Positivresists.

Wärme- bzw. hochwärmebeständige Photoresists werden insbesondere für die modernen Verfahren der Strukturierung und Dotierung von Halbleitern, d.h. für Trockenätzprozesse, wie Plasmaätzen oder reaktives Ionenätzen, und für Ionenimplantation, benötigt. Die Resistmaterialen bzw. die entsprechenden Reliefstrukturen dürfen sich dabei bei den hohen Temperaturen nicht zersetzen, und es dürfen sich auch keine Abweichungen in den Abmessungen der Reliefstrukturen, beispielsweise durch Erweichung oder Verzerrung, ergeben.

Herkömmliche Positivresists, wie diejenigen auf der Basis von Novolaken, entsprechen den erhöhten thermischen Anforderungen nur zum Teil, d.h. sie besitzen eine begrenzte Wärmeformbeständigkeit. Damit wird aber die Verfahrenssicherheit beeinträchtigt und die Verfahrensvorteile, wie Kantensteilheit, Feinstrukturierung, hohe Ätz- und Dotierungsrate, werden nachteilig beeinflusst.

Aus den deutschen Patentschriften Nrn. 2308830, 2437348, 2437368, 2437369, 2437383, 2437397, 2437413 und 2437422 sind wärmebeständige Negativresists bekannt. Diese negativ arbeitenden Photoresists eignen sich zwar in hervorragender Weise zur Herstellung hochwärmebeständiger Reliefstrukturen, sie unterliegen aber den Nachteilen, die den Negativresists eigen sind. Im Vergleich zu Negativresists zeichnen sich nämlich Positivresists insbesondere durch hohes Auflösungsvermögen, kurze Belichtungszeiten, die Verwendbarkeit wässerig-alkalischer Entwickler, was ökologisch und wirtschaftlich von Bedeutung ist, und durch die Tatsache aus, dass die Anwesenheit von Sauerstoff keinen Einfluss auf die Belichtungszeit hat.

Aus der deutschen Offenlegungsschrift Nr. 2631535 ist ein wärmebeständiger Positivresists bekannt, der ein lichtempfindliches o-Chinondiazid (o-Diazochinon) oder o-Naphthochinondiazid (o-Diazonaphthochinon) und eine Polyamidocarbonsäure in Form eines Polykondensationsproduktes aus einem aromatischen Dianhydrid und einer aromatischen Diaminoverbindung umfasst; die Polyamidocarbonsäure, in der genannten Offenlegungsschrift als „Polymicsäure" bezeichnet, stellt dabei eine Polymervorstufe dar und zwar die (polymere) Vorstufe eines Polymids.

Es hat sich nun aber gezeigt, dass die bekannte Positivresistzusammensetzung nur begrenzt lagerfähig ist, weil die Diazochinone in Gegenwart von Säuren nur eine sehr begrenzte Lagerstabilität aufweisen. Darüber hinaus ist auch die Stabilität des genannten Photoresists gegenüber alkalischen Ätzlösungen ungenügend. Ferner sind die Löslichkeitsunterschiede zwischen den belichteten und unbelichteten Teilen des Photoresists relativ gering.

Aufgabe der Erfindung ist es, Vorstufen von Polymeren enthaltende Positivresists der eingangs genannten Art anzugeben, die sowohl wärmebeständig als auch lagerfähig und gut verarbeitbar sind.

Dies wird erfindungsgemäss dadurch erreicht, dass die Positivresists oligomere und/oder polymere Vorstufen von Polyoxazolen in Form von Polykondensationsprodukten aus aromatischen und/oder heterocyclischen Dihydroxydiaminoverbindungen und Dicarbonsäurechloriden oder -estern enthalten.

Die erfindungsgemässen Positivresists sind bis zu Temperaturen von 550°C beständig. Sie werden somit auch den erhöhten Anforderungen gerecht, die bei modernen Trockenätztechniken und Ionenimplantationsverfahren gestellt werden. Diese Positivresists sind weiter für alkalische Nassätzprozesse einsetzbar. Sie können ferner sowohl in Form einer Resistlösung als auch als Trokkenresists eingesezt werden, d.h. unter Verwendung eines Trägermaterials, beispielsweise in Form einer Folie. Die Resists eignen sich insbesondere für Anwendungen in der Mikroelektronik (Herstellung feinstrukturierter Muster).

Den erfindungsgemässen Positivresists können die bei Positivresists üblichen Zusätze, wie Stabilisatoren, Farbstoffe bzw. Sensibilisatoren und Haftvermittler, zugegeben werden.

Die in der erfindungsgemässen Positivresists enthaltenen Vorstufen von Polyoxazolen sind Polyamidoalkohole, vorzugsweise Polyamidophenole. Diese Vorstufen weisen bevorzugt folgende Struktur auf:

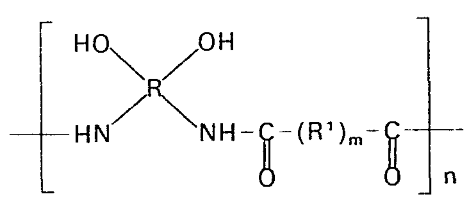

oder

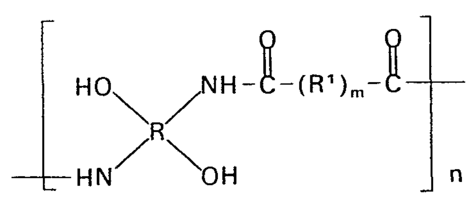

,

wobei n eine Zahl von 2 bis etwa 100 und m = 0 oder 1 ist. Die Gruppierung R Kann folgende Bedeutung haben:

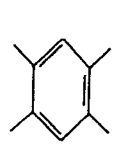

,

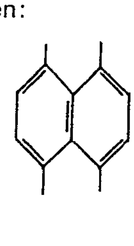

,

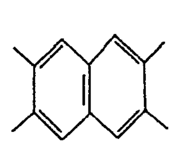

,

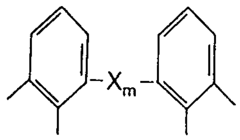 , 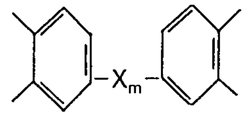 ,

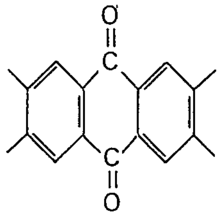 , 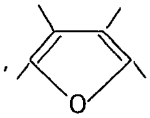 , 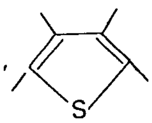 und

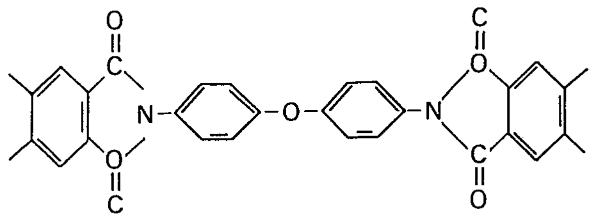 ,

Dabei ist m = 0 oder 1 und X bedeutet:

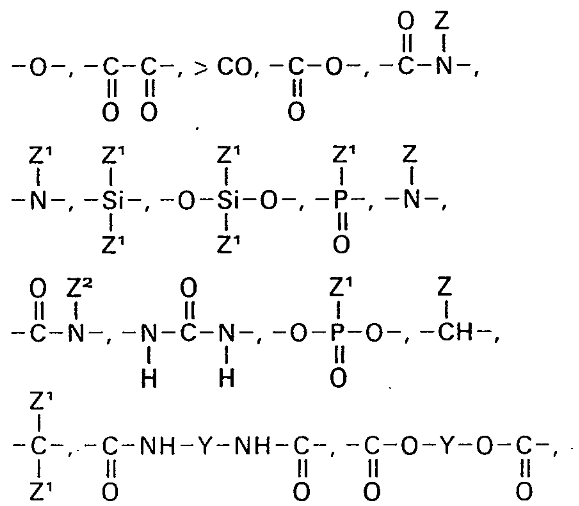

$-N=N-$, $-S-$, $-SO-$, $-SO_2-$, $-SO_2NH-$,

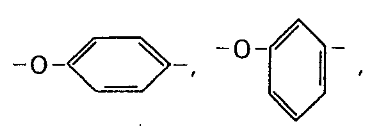 ,

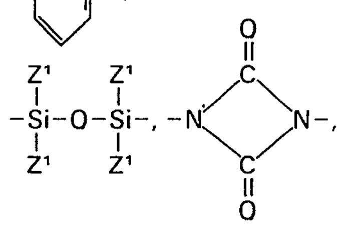

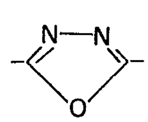 und 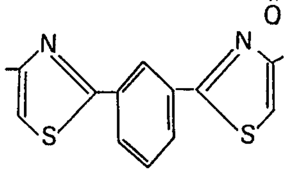 .

Für die weiteren Reste gilt:

Y = 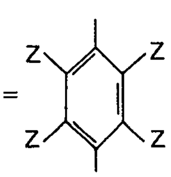 , $-(CH_2)_o-$ mit o = 2 bis 10, und

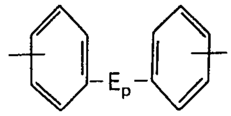 mit p = 0 oder 1;

Z = H oder Alkyl mit 1 bis 6 Kohlenstoffatomen,
$Z^1$ = Alkyl mit 1 bis 10 Kohlenstoffatomen oder Aryl, und
$Z^2$ = Aryl oder Heteroaryl.

E = 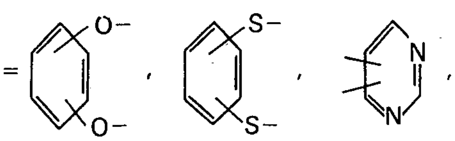

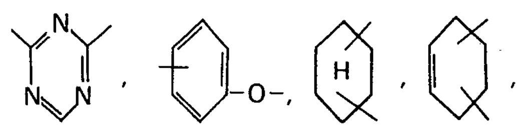

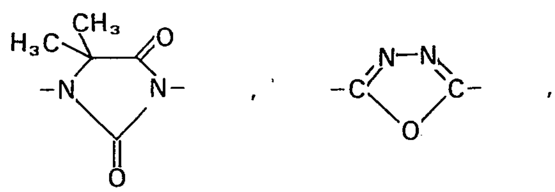

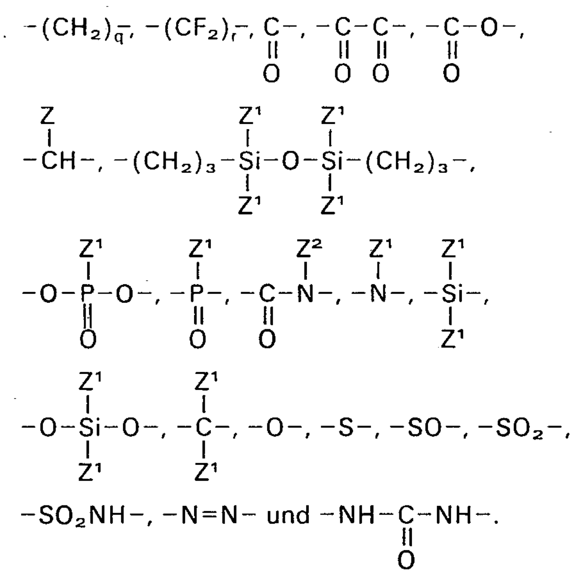

Dabei gilt: q = 2 bis 14 und r = 2 bis 18; $Z^1$ und $Z^2$ sind wie vorstehend definiert.

Die Gruppierung $R^1$ kann folgende Bedeutung haben, wobei H-Atome auch durch Cl oder Br substituiert sein können:

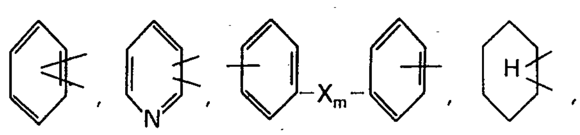

$-(CH_2)_q-$, $-(CF_2)_r-$, 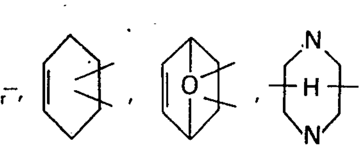

und 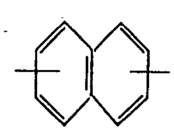 .

Dabei gilt: m = 0 oder 1; q = 2 bis 14; r = 2 bis 18.

X hat die vorstehend angegebene Bedeutung.

Die oligomeren bzw. polymeren Polyoxazolvorstufen werden, wie bereits ausgeführt, aus aromatischen oder heterocyclischen hydroxylgruppenhaltigen Diaminen und Dicarbonsäurechloriden oder -estern hergestellt. Vorzugsweise werden aromatische Diamine und aromatische Dicarbonsäurederivate eingesetzt, wobei Diamine mit phenolischen OH-Gruppen bevorzugt werden (Diaminodiphenole). Besonders geeignete Diaminodiphenole sind 3,3'-Dihydroxybenzidin und 3,3'-Dihydroxy-4,4'-diaminodiphenyläther, besonders geeignete Carbonsäurederivate Isophthalsäuredichlorid und Terephthalsäuredichlorid.

Die Polyoxazolvorstufen können durch eine thermische Behandlung relativ einfach in hochwärmebeständige Polyoxazole überführt werden. Die Polyoxazole sind in Luft und Stickstoff bis zu Temperaturen von etwa 550°C beständig und weisen eine ausgezeichnete chemische Resistenz gegenüber Lösungsmitteln, Säuren und insbesondere Laugen auf.

Lichtempfindliche Diazochinone (o-Chinon- und o-Naphthochinondiazide) sind beispielsweise aus folgenden US-Patentschriften bekannt: Nrn. 2767092, 2772972, 2797213, 3046118, 3106465, 3148983 und 3669658 (vgl. dazu auch: W.S. DeForest „Photoresists", McGraw-Hill Book Company, New York, 1975, S. 48 bis 55).

Bei den erfindungsgemässen Positivresists finden besonders bevorzugt solche Diazochinone Verwendung, die in wässerigen alkalischen Lösungen unlöslich sind, d.h. stark hydrophobe Eigenschaften aufweisen, und die nach der Belichtung in wässerigen alkalischen Entwicklern sehr stark löslich sind. Die Diazochinone sollen darüber hinaus gut verträglich mit der oligomeren bzw. polymeren Polyoxazolvorstufe sein und insbesondere nicht aus der Resistzusammensetzung auskristallisieren. Zu den besonders bevorzugten Diazochinonen mit dem genannten Eigenschaften zählen beispielsweise folgende Verbindungen:

N-Dehydroabietyl-6-diazo-5(6)-oxo-1-naphthalinsulfonamid

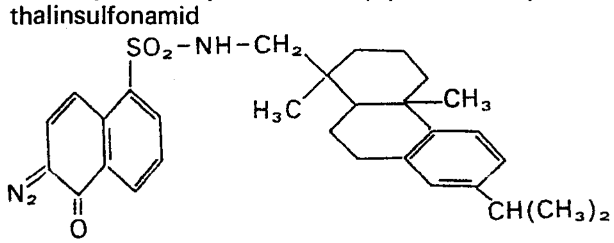

und der Bisnaphthochinon-[1.2]-diazid-(2)-5-sulfonsäureester von β,β-Bis-(4-hydroxyphenyl)-propan

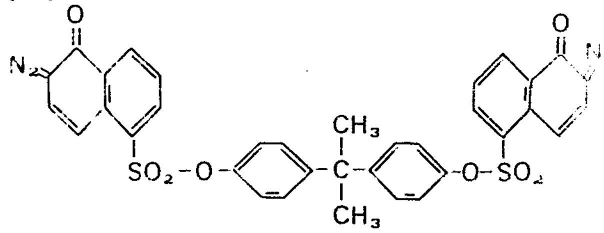

Weitere Verbindungen sind beispielsweise:

N-Dehydroabietyl-3-diazo-4(3)-oxo-1-naphthalinsulfonamid,

N-Dehydroabietyl-[5.6.7.8]-tetrahydro-4-diazo-3(4)-oxo-2-naphthalinsulfonamid, und

N-Dextropimaryl-3-diazo-4-oxo-[1.5]-cyclohexadien-1-sulfonamid.

Zur Herstellung wärmebeständiger Reliefstrukturen wird ein erfindungsgemässer Positivresist in Form einer Schicht oder Folie auf ein Substrat aufgebracht und mit aktinischem Licht durch eine Maske belichtet oder durch Führen eines Licht-, Elektronen- oder Ionenstrahls bestrahlt. Anschliessend werden die belichteten bzw. bestrahlten Schicht- oder Folienteile herausgelöst oder abgezogen und die dabei erhaltenen Reliefstrukturen werden dann getempert.

Der Photoresist kann vorteilhaft in einem organischen Lösungsmittel gelöst auf das Substrat aufgebracht werden. Zur Herstellung dieser Resistlösung kann das Diazochinon mit einer Lösung der oligomeren oder polymeren Vorstufe in N-Methylpyrrolidon, Dimethylformamid, Dimethylacetamid oder einem ähnlichen Lösungsmittel als Festsubstanz oder auch als Lösung in einem der genannten Lösungsmittel vermischt werden. Vorzugsweise wird als Lösungsmittel N-Methylpyrrolidon verwendet. Das Gewichtsverhältnis von Oligomer bzw. Prepolymer zu Diazochinon beträgt dabei im allgemeinen 1:20 bis 20:1, vorzugsweise 1:10 bis 10:1.

Die Konzentration der Resistlösung kann so eingestellt werden, dass mit bekannten Beschichtungsverfahren, wie Schleudern, Tauchen, Sprühen, Bürsten oder Rollen, Schichtstärken von 0,01 µm bis einige 100 µm erzeugt werden können. Es hat sich gezeigt, dass beispielsweise beim Schleuderbeschichten 300 bis 10 000 tr/min für die Dauer von 1 bis 100 s geeignet sind, um eine gleichmässige und gute Oberflächenqualität zu erzielen. Die auf das Substrat, das vorzugsweise aus Glas, Metall, Kunststoff oder halbleitendem Material besteht, aufgebrachte Photoresistschicht kann bei Raumtemperatur oder bei erhöhter Temperatur, vorzugsweise bei einer Temperatur von 50 bis 120°C, vom Lösungsmittel befreit werden: dabei kann auch im Vakuum gearbeitet werden.

Zur Erzielung eines ausreichenden Löslichkeitsunterschiedes zwischen den bestrahlten und den nicht bestrahlten Schicht- bzw. Folienteilen genügen bei den erfindungsgemässen Positivresists – bei der Verwendung einer 500-W-Quecksilberhöchstdrucklampe – in Abhängigkeit von der verwendeten Resistzusammensetzung und der Schichtstärke Belichtungszeiten zwischen 1 und 600 s.

Nach dem Belichten werden die belichteten Teile der Schicht bzw. Folie mit einem wässerig-alkalischen Entwickler herausgelöst. Der Entwickler kann Alkalimetallsalze von starken und schwachen Säuren, wie Natriumcarbonat und Natriumphosphat, aber auch Natriumhydroxid und organische Basen, wie Piperidin und Triäthanolamin, sowie oberflächenaktive Stoffe enthalten. Im allgemeinen enthält der Entwickler etwa 0,01 bis 25%

einer vorzugsweise organischen Base. Die Entwicklungszeit wird empirisch ermittelt und beträgt etwa 5 bis 190 s bei Raumtemperatur.

Mittels der erfindungsgemässen Positivresists werden konturenscharfe Bilder, d.h. Reliefstrukturen, erhalten, die durch Temperung in hochwärmebeständige, gegenüber Säuren und insbesondere Laugen äusserst resistente Polymere umgewandelt werden. Im allgemeinen können Temperaturen von 220 bis 500°C gewählt werden, vorzugsweise wird bei Temperaturen von 300 bis 400°C getempert. Die Temperzeit beträgt im allgemeinen ½ h, wobei keine Verfärbung, sowohl unter Stickstoff als auch an Luft, zu beobachten ist. Die Kantenschärfe und die Massgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Besonders bemerkenswert ist die Resistenz der erfindungsgemässen Photoresists gegen alkalisches Ätzen. Auf diese Weise können Strukturen auf Metallsubstrate übertragen werden oder durch Lösen einer metallischen Trägerfolie, die vorzugsweise aus Aluminium besteht, Folien bzw. strukturierte Folien hergestellt werden.

Die nach dem erfindungsgemässen Verfahren hergestellten Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Nass- und Trockenätzprozesse, stromlose oder galvanische Metallabscheidung und Aufdampfverfahren sowie als Masken für die Ionenimplantation darüber hinaus als Isolier- und Schutzschichten in der Elektrotechnik. Diese Reliefstrukturen können ferner vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden.

Anhand von Ausführungsbeispielen soll die Erfindung noch näher erläutert werden.

*Beispiel 1:*

Durch Vermischen der einzelnen Bestandteile wird eine Photoresistlösung folgender Zusammensetzung hergestellt: 17 Gewichtsteile einer Polybenzoxazolvorstufe, hergestellt aus 3,3'-Dihydroxybenzidin und Isophthalsäurechlorid (vgl.: „Polymer Letters", vol. 2, 1964, S. 655), 17 Gewichtsteile des Bisnaphthochinon-[1.2]-diazid-(2)-5-sulfonsäureesters von β,β-Bis-(4-hydroxyphenyl)propan und 200 Gewichtsteile N-Methylpyrrolidon.

Die fertige Lösung wird durch ein 0,8-µm-Filter filtriert und auf eine Aluminiumfolie geschleudert. Bei 500 tr/min wird eine Schichtstärke von 1,5 µm erhalten. Die Trockenzeit beträgt 90 min bei einer Temperatur von 60°C im Vakuum. Mit einer 500-W-Quecksilberhöchstdrucklampe wird dann 5 s lang durch eine Kontaktmaske belichtet und danach 45 s mit einer 5%igen Natriumphosphatlösung sprühentwickelt. Es werden kantenscharfe Strukturen von ca. 2 µm erhalten, die beim Tempern in Luft bei einer Temperatur von 300°C während 30 min keine Farbänderung oder Beeinträchtigung der Dimensionsgenauigkeit erfahren. Nach dem Tempern beträgt die Schichtdicke 1,3 µm, sie sinkt bei weiterem halbstündigen Tempern bei 400°C auf 0,8 µm, ohne dass sich die Strukturen verändern. Auch durch 14stündiges Tempern bei 350°C wird die Qualität der Reliefstrukturen nicht beeinträchtigt. Die Haftung der Reliefstrukturen auf der Unterlage ist hervorragend.

*Beispiel 2:*

Eine Lösung von 20 Gewichtsteilen der Polybenzoxazolvorstufe gemäss Beispiel 1 und 8 Gewichtsteilen des Bisnaphthochinon-[1.2]-diazid-(2)-5-sulfonsäureesters von β,β-Bis-(4-hydroxyphenyl)propan in 80 Volumenteilen N-Methylpyrrolidon wird filtriert und dann bei 2000 tr/min auf eine mit Hexamethyldisilazan beschichtete Aluminiumfolie geschleudert. Nach 2stündigem Trocknen im Vakuum bei 60°C beträgt die Schichtstärke 13 µm. Mit einer 500-W-Quecksilberhöchstdrucklampe wird dann 6 min durch eine Kontaktmaske belichtet. Nach einer Entwicklungszeit von 2 min mit einer 10%igen wässerigen Natriumphosphatlösung werden konturenscharfe Reliefbilder erhalten.

*Beispiel 3:*

Eine Lösung von 2 Gewichtsteilen der in Beispiel 1 beschriebenen Polymervorstufe und 0,4 Gewichtsteilen des Diazonaphthochinons nach Beispiel 1 in 20 Volumenteilen N-Methylpyrrolidon wird bei 2000 tr/min auf eine Aluminiumfolie geschleudert. Nach dem Trocknen im Vakuum (90 min bei 60°C) werden 1,5 µm starke Schichten erhalten. Nach einer Belichtung von 10 s mit einer 500-W-Quecksilberhöchstdrucklampe durch eine Kontaktmaske und anschliessendem Entwickeln mit einer 2,5%igen Natriumphosphatlösung (Dauer: 15 s) werden hochaufgelöste ($\leqslant$ 2,5 µm), kantenscharfe Reliefstrukturen erhalten.

*Beispiel 4:*

Die Photoresistlösung nach Beispiel 3 wird auf einen mit Hexamethyldisilazan beschichteten Siliziumwafer zu einem 3,6 µm starken Film geschleudert. Nach einer Belichtung von 6 s durch eine Testmaske mit einer 500-W-Quecksilberhöchstdrucklampe und nach einer Entwicklung von 15 s mit einer 2,5%igen Natriumphosphatlösung werden konturenscharfe Reliefstrukturen mit einer Auflösung von 2 bis 2,5 µm erhalten. Nach einstündigem Tempern bei 300°C sinkt die

Schichtstärke auf 2,5 µm und nach weiterem halbstündigen Erhitzen bei 400°C auf 2,2 µm. Auflösung, Haftung und Farbe der Reliefstrukturen werden durch die Temperung nicht beeinflusst.

*Beispiel 5:*

Die in Beispiel 2 beschriebene Resistlösung wird bei 1000 tr/min zu 22 µm starken Filmen auf Aluminium geschleudert, 25 min bildmässig mit einer 500-W-Quecksilberhöchstdrucklampe belichtet und dann 4 min mit einer 10%igen Natriumphosphatlösung entwickelt. Nach 4 bis 6 min kann die strukturierte Folie vom Substrat entfernt werden.

*Beispiel 6:*

Eine gemäss Beispiel 1 hergestellte Photoresistlösung wird bei 500 tr/min zu einem 1,5 µm starken Film auf eine Aluminiumfolie geschleudert, getrocknet, 5 s lang durch eine Kontaktmaske mit einer 500-W-Quecksilberhöchstdrucklampe belichtet und danach 45 s lang mit einer 5%igen Natriumphosphatlösung entwickelt. Die entsprechend Beispiel 1 getemperte Aluminiumfolie mit der Polybenzoxazolreliefstruktur wird bei Raumtemperatur für 2 min in eine 5%ige Natriumhydroxidlösung gelegt. Während dabei die Aluminiumunterlage angeätzt wird, zeigt die Polybenzoxazolreliefstruktur keine Beeinträchtigung der Oberflächenqualität und der Haftung.

*Beispiel 7:*

Wird die in Beispiel 6 beschriebene Reliefstruktur auf Aluminium für 2 min in ein Säurebad aus 800 Volumenteilen konz. Phosphorsäure, 50 Volumenteilen konz. Salpetersäure, 50 Volumenteilen konz. Essigsäure und 100 Volumenteilen entionisierten Wassers gelegt, so lassen sich in das Aluminium 8 µm tiefe Strukturen übertragen.

*Beispiel 8:*

Eine Positivresistlösung aus 2 Gewichtsteilen der in Beispiel 1 beschriebenen Polybenzoxazolvorstufe und 0,6 Gewichtsteilen N-Dehydroabietyl-6-diazo-5(6)-oxo-1-naphthalinsulfonamid in 20 Volumenteilen N-Methylpyrrolidon wird bei 1000 tr/min auf eine mit Hexamethyldisilazan vorbehandelte Aluminiumfolie geschleudert und danach 1h bei 60°C im Vakuum getrocknet. Nach einer Belichtung von 2 s mit einer 500-W-Quecksilberhöchstdrucklampe durch eine Maske werden nach einer Tauchentwicklung von 30 s mit einer 2,5%igen wässerigen Natriumphosphatlösung kantenscharfe Reliefstrukturen erhalten. Die Auflösung beträgt bei einer Schichtstärke von 1,6 µm etwa 1,8 µm.

## Patentansprüche

1. Wärmebeständige Positivresists auf der Basis von Vorstufen hochwärmebeständiger Polymere und lichtempfindlichen Diazochinonen, dadurch gekennzeichnet, dass sie oligomere und/oder polymere Vorstufen von Polyoxazolen in Form von Polykondensationsprodukten aus aromatischen und/oder heterocyclischen Dihydroxydiaminoverbindungen und Dicarbonsäurechloriden oder -estern enthalten.

2. Positivresists nach dem Anspruch 1, dadurch gekennzeichnet, dass die Polymervorstufe ein Kondensationsprodukt aus 3,3'-Dihydroxybenzidin und Isophthalsäuredichlorid ist.

3. Positivresists nach dem Anspruch 1, dadurch gekennzeichnet, dass die Polymervorstufe ein Kondensationsprodukt aus 3,3'-Dihydroxy-4,4'-diaminodiphenyläther und Terephthalsäuredichlorid ist.

4. Positivresists nach einem der Ansprüche 1 bis 3, dadurch gekennzeichnet, dass das Diazochinon der Bisnaphthochinon-[1.2]-diazid-(2)-5-sulfonsäureester von β,β-Bis-(4-hydroxyphenyl)propan ist.

5. Positivresists nach einem der Ansprüche 1 bis 3, dadurch gekennzeichnet, dass das Diazochinon N-Dehydroabietyl-6-diazo-5(6)-oxo-1-naphthalinsulfonamid ist.

6. Positivresists nach einem der Ansprüche 1 bis 5, dadurch gekennzeichnet, dass das Gewichtsverhältnis von Polymervorstufe zu Diazochinon zwischen 1:20 und 20:1, vorzugsweise zwischen 1:10 und 10:1, beträgt.

7. Verfahren zur Herstellung wärmebeständiger Reliefstrukturen, dadurch gekennzeichnet, dass ein Positivresist nach einem der Ansprüche 1 bis 6 in Form einer Schicht oder Folie auf ein Substrat aufgebracht und mit aktinischem Licht durch eine Maske belichtet oder durch Führen eines Licht-, Elektronen- oder Ionenstrahls bestrahlt wird, dass die belichteten bzw. bestrahlten Schicht- oder Folienteile herausgelöst oder abgezogen und die dabei erhaltenen Reliefstrukturen getempert werden.

8. Verfahren nach dem Anspruch 7, dadurch gekennzeichnet, dass der Positivresist in einem organischen Lösungsmittel gelöst auf das Substrat aufgebracht wird.

9. Verfahren nach dem Anspruch 8, dadurch gekennzeichnet, dass als Lösungsmittel N-Methylpyrrolidon verwendet wird.

10. Verfahren nach einem der Ansprüche 7 bis 9, dadurch gekennzeichnet, dass ein Substrat aus Glas, Metall, insbesondere Aluminium, Kunststoff oder halbleitendem Material verwendet wird.

11. Verfahren nach einem oder mehreren der Ansprüche 7 bis 10, dadurch gekennzeichnet, dass die Reliefstrukturen auf eine Temperatur oberhalb 200°C, vorzugsweise auf 300 bis 350°C, erhitzt werden.

12. Verfahren nach einem oder mehreren der Ansprüche 7 bis 11, dadurch gekennzeichnet, dass die getemperte Reliefstruktur vom Substrat abgelöst und gegebenenfalls auf ein anderes Substrat übertragen wird.

## Claims

1. Heat-resistant positive resists having a basis of precursors of highly heat-resistant polymers and light-sensitive diazoquinones, characterised in

that they contain oligomeric and/or polymeric precursors of polyoxazoles in the form of polycondensation products of aromatic and/or heterocyclic dihydroxydiamino-compounds and dicarboxylic acid chlorides or esters.

2. Positive resists as claimed in claim 1, characterised in that the polymer precursor is a condensation product of 3,3'-dihydroxybenzidine and isophthalic acid dichloride.

3. Positive resists as claimed in claim 1, characterised int that the polymer precursor is a condensation product of 3,3'-dihydroxy-4,4'-diaminodiphenylether and terephthalic acid dichloride.

4. Positive resists as claimed in one of claims 1 to 3, characterised in that the diazoquinone is the bisnaphthoquinone-[1.2]-diazide-(2)-5-sulphonic acid ester of β,β-bis-(4-hydroxyphenyl)propane.

5. Positive resists as claimed in one of claims 1 to 3, characterised in that the diazoquinone is N-dehydroabietyl-6-diazo-5(6)-oxo-1-naphthalenesulphonamide.

6. Positive resists as claimed in one of claims 1 to 5, characterised in that the weight ratio of polymer precursor to diazoquinone is between 1:20 and 20:1, preferably between 1:10 and 10:1.

7. A process for the production of heat-resistant relief structures, characterised in that a positive resist in accordance with one of claims 1 to 6 is applied in the form of a layer or film to a substrate, exposed to actinic light through a mask, or irradiated by the guidance of a light beam, electron beam, or ion beam; and that the exposed or irradiated parts of the layer or film are dissolved away or stripped off and the relief structures thereby obtained are annealed.

8. A process as claimed in claim 7, characterised in that the positive resists is applied to the substrate in solution in an organic solvent.

9. A process as claimed in claim 8, characterised in that the solvent is N-methylpyrrolidone.

10. A process as claimed in one of claims 7 to 9, characterised in that a substrate which consists of glass, a metal (in particular aluminium) synthetic resin, or semiconducting material is used.

11. A process as claimed in one or more of claims 7 to 10, characterised in that the relief structures are heated to a temperature of above 200°C, preferably from 300 to 350°C.

12. A process as claimed in one or more of claims 7 to 11, characterised in that the annealed relief structure is stripped from the substrate and, if necessary, transferred to another substrate.

## Revendications

1. Compositions photorésistantes positives résistant à la chaleur à base de précurseurs de polymères ayant une résistance élevée à la chaleur et de diazoquinones photosensibles, caractérisées en ce qu'elles contiennent des précurseurs oligomères et/ou polymères de polyoxazoles sous forme de produit de polycondensation de composés dihydroxydiamino aromatiques et/ou hétérocycliques et de chlorures ou d'esters d'acides dicarboxyliques.

2. Compositions photorésistantes positives suivant la revendication 1, caractérisées en ce que le précurseur de polymère est un produit de condensation de 3,3'-dihydroxybenzidine et de dichlorure d'acide isophtalique.

3. Compositions photorésistantes positives suivant la revendication 1, caractérisées en ce que le précurseur de polymère est un produit de condensation d'éther 3,3'-dihydroxy-4,4'-diaminodiphénylique et de dichlorure d'acide téréphtalique.

4. Compositions photorésistantes positives selon l'une des revendications 1 à 3, caractérisées en ce que la diazoquinone est le bisnaphtoquinone-[1.2]-diazide-(2)-5-sulfonate de β,β-bis-(4-hydroxyphényl)propane.

5. Compositions photorésistantes positives suivant l'une des revendications 1 à 3, caractérisées en ce que la diazoquinone est le N-déhydroabiétyl-6-diazo-5(6)-oxo-1-naphtalène sulfonamide.

6. Compositions photorésistantes positives suivant l'une des revendications 1 à 5, caractérisées en ce que le rapport pondéral du précurseur de polymères à la diazoquinone est compris entre 1:20 et 20:1, de préférence entre 1:10 et 10:1.

7. Procédé de préparation de structures en relief résistant à la chaleur, caractérisé en ce qu'il consiste à appliquer une composition photorésistante positive suivant l'une des revendications 1 à 6 sous la forme d'une feuille ou d'une couche sur un substrat et à l'exposer à la lumière actinique à travers un masque ou à l'irradier en envoyant un faisceau de lumière, d'électrons ou d'ions, à dissoudre ou à enlever les parties de couche ou de feuille exposées ou irradiées et à recuire les structures en relief ainsi obtenues.

8. Procédé suivant la revendication 7, caractérisé en ce qu'il consiste à appliquer la composition photorésistante positive sur le substrat alors qu'elle est à l'état dissous dans un solvant organique.

9. Procédé suivant la revendication 8, caractérisé en ce qu'il consiste à utiliser comme solvant la N-méthylpyrrolidone.

10. Procédé suivant l'une des revendications 7 à 9, caractérisé en ce qu'il consiste à utiliser un substrat en verre ou en métal, notamment en aluminium, en matière plastique ou en un matériau semi-conducteur.

11. Procédé suivant une ou plusieurs des revendications 7 à 10, caractérisé en ce qu'il consiste à chauffer les structures en relief à une température supérieure à 200°C, de préférence allant de 300 à 350°C.

12. Procédé suivant l'une ou plusieurs des revendications 7 à 11, caractérisé en ce qu'il consiste à séparer du substrat, par dissolution, la structure en relief recuite et, le cas échéant, à la transférer sur un autre substrat.